Europäisches Patentamt

European Patent Office

Office européen des brevets

(11) Veröffentlichungsnummer: **0 076 373**

A2

(12) **EUROPÄISCHE PATENTANMELDUNG**

(21) Anmeldenummer: 82107392.1

(22) Anmeldetag: 13.08.82

(51) Int. Cl.³: **G 02 B 5/14**
G 02 F 1/01, G 02 F 1/00

(30) Priorität: 29.09.81 DE 3138727

(43) Veröffentlichungstag der Anmeldung:
13.04.83 Patentblatt 83/15

(84) Benannte Vertragsstaaten:
FR GB

(71) Anmelder: SIEMENS AKTIENGESELLSCHAFT
Berlin und München Wittelsbacherplatz 2
D-8000 München 2(DE)

(72) Erfinder: Auracher, Franz, Dr. Ing.
Eichenstrasse 26
D-8021 Baierbrunn(DE)

(72) Erfinder: Stockmann, Michael, Dipl.-Phys.
Plievierpark 10
D-8000 München 83(DE)

(54) Frequenzanalysator in planarer Wellenleitertechnologie und Verfahren zur Herstellung einer planaren geodätischen Linse auf oder in einem Substrat.

(57) Bei einem Frequenzanalysator in planarer Wellenleitertechnologie läßt sich bisher nur die Bragg-Zelle durch Verwendung fotolithografischer Prozesse kostengünstig fertigen. Die Herstellung der außerdem nötigen leistungsfähigen Wellenleiterlinsen für die Fourier-Transformation ist immer noch sehr aufwendig. Es soll aufgezeigt werden, wie auch diese Linsen und damit der gesamte Frequenzanalysator kostengünstig hergestellt werden können bzw. kann. Dazu wird ein Design vorgeschlagen, das für den linsenoptischen Teil des Frequenzanalysators ein anderes Substratmaterial vorsieht, als für die Bragg-Zelle, und zwar ein Substratmaterial, in dem die geodätische Wellenleiterlinse durch Pressen mit einem Stempel erzeugbar ist. Dadurch können auch die Herstellungskosten für Anlagen parallel betriebener Frequenzanalysatoren in planarer Wellenleitertechnologie gesenkt werden, indem eine rotationssymmetrische Wellenleiterlinse gemeinsam von mehreren Wellenleitermodulatoren zur Fourier-Transformation der HF-Signale benutzt wird.

FIG 1a

SIEMENS AKTIENGESELLSCHAFT          Unser Zeichen
Berlin und München                  VPA

81 ᵒ 7141 E

Frequenzanalysator in planarer Wellenleitertechnologie
und Verfahren zur Herstellung einer planaren, geodätischen Linse auf oder in einem Substrat

Die Erfindung bezieht sich auf einen Frequenzanalysator
in planarer Wellenleitertechnologie nach dem Oberbegriff des Patentanspruchs 1 und auf ein Verfahren zur
Herstellung einer planaren, geodätischen Linse auf oder
in einem Substrat.

Zur Frequenzanalyse von HF-Signalen können akustooptische HF-Frequenzanalysatoren verwendet werden, die auf
einfache Art die Frequenzanalyse in "real-time" ermöglichen. Insbesondere ist der Einsatz eines akustooptischen
Frequenzanalysators in planarer Wellenleitertechnologie
(siehe M.K. Barnoski et al, Integratet-Optic Spectrum
Analyzer, IEEE Transactions on Circuits and Systems,
Vol. Cas.-26, No. 12 (Dez. 1979) 1113-1124) von Interesse. Diese Technik bietet wegen des kompakten Aufbaus
den Vorteil der mechanischen Stabilität, was bei Geräten zur optisch kohärenten Signalverarbeitung äußerst
wichtig ist. Außerdem erlaubt der planare Aufbau den
Einsatz kostengünstiger Herstellungsverfahren, wie
beispielsweise die Fotolithografie.

Der bisher am häufigsten verfolgte Weg zur Realisierung
eines planaren Frequenzanalysators sieht ein Substrat
aus monokristallinem $LiNbO_3$ mit Ti-eindiffundiertem,
optischem Wellenleiter vor. Das Licht wird mit einem
Gas-oder Halbleiterlaser in den Wellenleiter über dessen
Stirnfläche eingekoppelt und trifft auf eine auf der
entgegengesetzten Stirnfläche des Wellenleiters ange-
Ed 1 Sti/28.9.81 koppelte Fotodetektorzeile. Ein Wellenleitermodulator
eines modulatoroptischen Teils umfaßt einen zur Erzeugung einer Oberflächenschallwelle dienenden elektroakustischen Wandler, der fotolithografisch auf das
Substrat aufgebracht werden kann. Ein linsenoptischer
Teil umfaßt eine geodätische Linse zur Fourier-Transformation und auch eine geodätische Linse zur Kollimation von Licht. Die Linsen können durch Ultraschallerosion oder mit einem Diamantdrehverfahren im Substrat erzeugt werden (siehe B. Chen, O.G.Ramer:
Diffraction-Limited Geodesic Lens for Integrated
Optic Circuit, IEEE L. Quant. Electr., Vol. QE-15,
Nr. 9 (1979) 853-860 und D.Mergerian et al: Diamond-
Turned Aspheric Geodesic Waveguide Lenses in Lithium
Niobate, Integrated Guided-Wave Optics Technical
Digest, Incline Village, NV, USA, 1980, ME4).

Bei der Herstellung dieser Linsen gibt es noch vielfältige Probleme. Beim Ultraschall-Erosionsverfahren
können im Prinzip mit einem hochpräzise gefertigten
Werkzeug mehrere Linsen hergestellt werden. Jedoch
erwies sich die Abnutzung des Werkzeugs als zu groß,
um die geodätischen Strukturen reproduzierbar herstellen zu können. Das Diamant-Drehverfahren scheint
dagegen reproduzierbare Ergebnisse zu liefern, jedoch
muß jede Linse mit dem gleichen Aufwand einzeln gefertigt und von Hand nachpoliert werden, was einer
kostengünstigen Herstellung im Wege steht.

Aufgabe der Erfindung ist es, einen Frequenzanalysator
der genannten Art anzugeben, der kostengünstig herstellbar ist.

Diese Aufgabe wird durch die im kennzeichnenden Teil
des Patentanspruchs 1 angegebenen Merkmale gelöst.

Diese Lösung ermöglicht es, zumindest die Linse für
die Fourier-Transformation aus einem Material zu
fertigen, das eine kostengünstige Herstellung der
Linse erlaubt.

Eine kostengünstige Herstellung der Linse und damit
des Frequenzanalysators ermöglichen gemäß den Ansprüchen
2 und 3 Materialien, in denen eine geodätische Linse
durch Pressen, insbesondere in einem Heißpreßverfahren,
erzeugbar ist.

Eine kostengünstige Herstellung des erfindungsgemäßen
Frequenzanalysators ermöglichen gemäß den Ansprüchen
4 und 5 auch Materialien, in denen eine
Gradientenlinse, die insbesondere die Form eines Stabes
aufweist, ausgebildet ist.

Substratmaterialien, in denen eine Linse durch Pressen
erzeugbar oder eine Gradientenlinse ausbildbar ist,
sind gemäß Anspruch 6 ein Glas oder ein Kunststoff.

Das Substratmaterial für den modulatoroptischen Teil
besteht gemäß Anspruch 7 aus LiNbO$_3$, dessen Materialeigenschaften eine optimale akustooptische Wechselwirkung gewährleisten und damit den günstigen Einsatz
eines elektroakustischen Wandlers als Wellenleitermodulator ermöglichen. Beim elektroakustischen Wandler
handelt es sich stets um eine interdigitale Elektrodenstruktur in breitbandiger Ausführung oder um eine Anordnung von mehreren schmalbandigen Wandlern.

Zweckmäßig ist es, gemäß Anspruch 8, die Bauteile aus
verschiedenen Substratmaterialien durch Stoßkopplung
miteinander zu verbinden, wobei es zur Vermeidung von
Fresnel-Reflexionen wiederum zweckmäßig ist, gemäß
Anspruch 9 eine Antireflexschicht zwischen den stoßgekoppelten Teilen vorzusehen.

Ein erfindungsgemäßer Frequenzanalysator ist gemäß
Anspruch 10 zweckmäßigerweise so ausgebildet, daß
der linsenoptische Teil eine einem Wellenleitermodulator des modulatoroptischen Teils vorgeordnete,
in einem vom Substratmaterial des modulatoroptischen
Teils verschiedenen Substratmaterial ausgebildete
geodätische Linse für eine Kollimation des in den
Wellenleitermodulator einzukoppelnden Lichts aufweist.
Wie für die Linse zur Fourier-Transformation kann auch
für die Linse zur Kollimation ein Substratmaterial
verwendet werden, daß eine einfache Herstellung auch
dieser Linse und damit des gesamten Frequenzanalysators
ermöglicht.

Ein besonders vorteilhafter Aufbau eines erfindungsgemäßen Frequenzanalysators ist gemäß Anspruch 11 so aufgebaut, daß die als rotationssymmetrische Wellenleiterlinse ausgebildete geodätische Linse für die Fourier-
Transformation mehreren über den Umfang der Linse verteilten Wellenleitermodulatoren des modulatoroptischen
Teils als gemeinsame Linse zur Fourier-Transformation
nachgeordnet ist, wobei diese gemeinsame Linse zweckmäßigerweise, gemäß Anspruch 12, auf oder in einem polygonförmigen Substrat ausgebildet ist, an dessen Seitenflächen die mehreren Wellenleitermodulatoren des
modulatoroptischen Teils stoßgekoppelt sind.

Dieser Aufbau eines Frequenzanalysators gemäß Anspruch
11 ist aber nicht auf einen erfindungsgemäßen Frequenzanalysator beschränkt, sondern ist generell als
vorteilhafter Aufbau eines Frequenzanalysators anzusehen, der auch in anderen Techniken realisiert werden
kann.

Ein besonders einfaches und zweckmäßiges Verfahren
zur Herstellung einer geodätischen Linse auf oder in einem Substrat, das insbesondere zur kostengünstigen Herstellung eines erfindungsgemäßen Frequenzanalysators geeignet ist, ist in dem Anspruch 13 angegeben, wonach die Struktur der Linse in das aus geeignetem Material bestehende Substrat eingeprägt oder gepreßt wird, gemäß Anspruch 14 insbesondere in einem Heißpreßverfahren eingepreßt wird und wonach auf oder unter der geprägten Fläche ein planarer Wellenleiter erzeugt wird.

Als Substratmaterial sind insbesondere Glas oder transparenter Kunststoff geeignet (Anspruch 15).

Die Struktur der Linse wird gemäß Anspruch 16 mit einem in einer numerisch gesteuerten Drehbank gefertigten Stempel mit der Negativform der Struktur der Linse erzeugt.

Der planare Wellenleiter kann auf verschiedenste Weisen erzeugt werden, beispielsweise kann er auf die geprägte Fläche durch Abscheiden von einer oder mehreren Schichten oder durch Einbringen von Dotierstoffen unter die geprägte Fläche mittels Ionenimplantation oder Diffusion erzeugt werden.

Ausführungsbeispiele der Erfindung sind in den Figuren schematisch dargestellt und werden in der folgenden Beschreibung näher erläutert. Von den Figuren zeigen

Figur 1a und 1b eine Draufsicht und Seitenansicht eines ersten Ausführungsbeispiels,

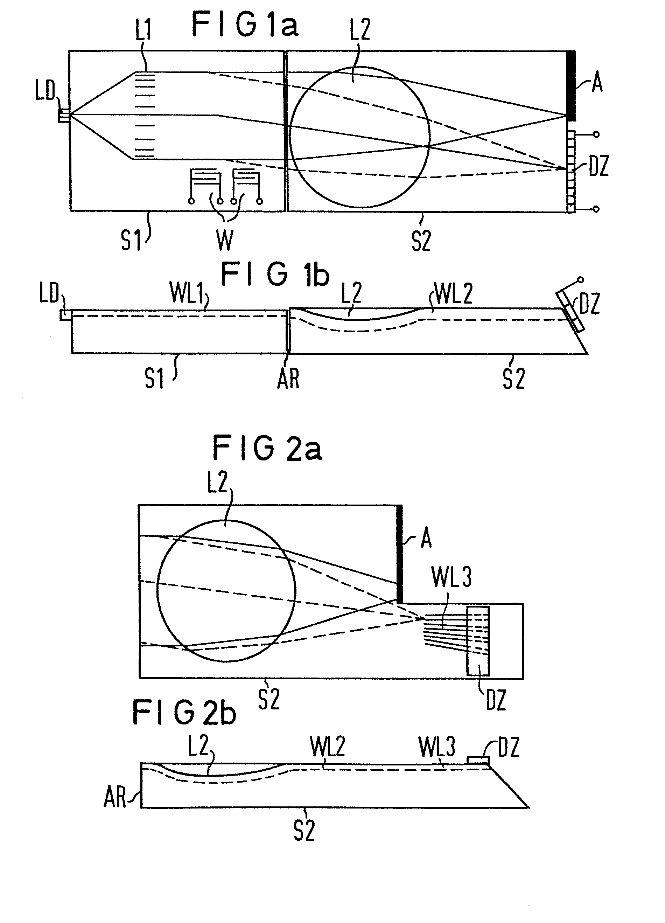

Figur 2a und 2b eine Draufsicht und Seitenansicht eines linsenoptischen Teils für einen Frequenzanalysator, die eine Detektorzeile und eine spezielle Auskoppelvorrichtung aufweist, und die beispielsweise anstelle des linsenoptischen Teils
des Ausführungsbeispiels nach den
Figuren 1a und 1b verwendet werden
könnte,

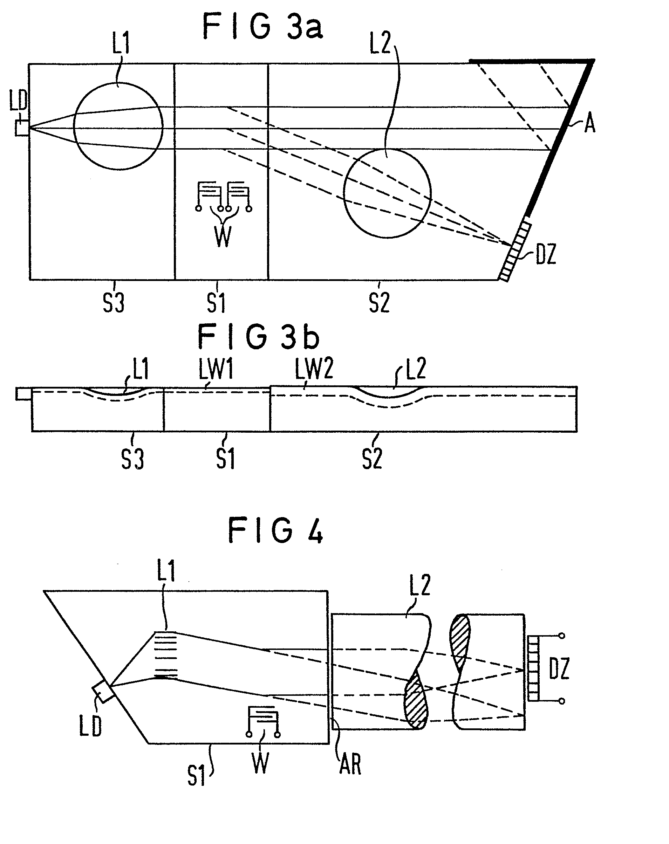

Figur 3a und 3 b eine Draufsicht und Seitenansicht
eines Ausführungsbeispiels eines
Frequenzanalysators, bei welchem eine
dem Wellenleitermodulator vorgeordnete
Linse zur Kollimation von Licht verwendet ist, die auf gleiche Weise herstellt ist, wie die Linse für die
Fourier-Transformation,

Figur 4 ein Ausführungsbeispiel eines Frequenzanalysators, bei dem die Linse für die Fourier-
Transformation eine stabförmige Gradientenlinse ist,

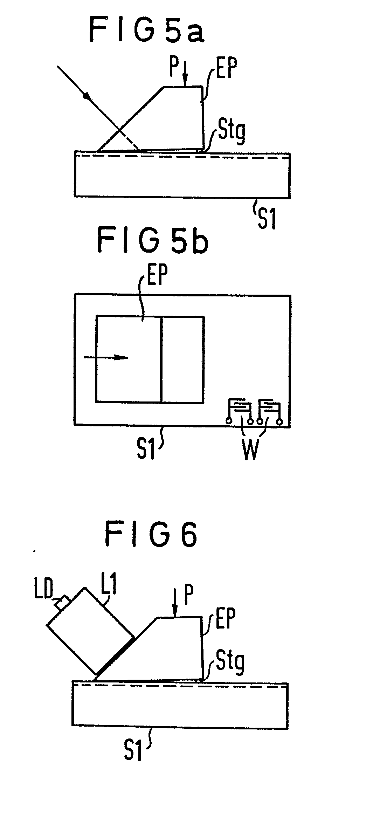

Figur 5a und 5b eine Seitenansicht und Draufsicht auf
eine Einkoppelvorrichtung zum Einkoppeln von Licht in den planaren
Wellenleitermodulator über ein Einkoppelprisma,

Figur 6 eine Seitenansicht einer Einkoppelvorrichtung
gemäß den Figuren 5a und 5b, bei der dem
Einkoppelprisma eine als Gradientenlinse ausgebildete Linse zur Kollimation von Licht
vorgeordnet ist, und

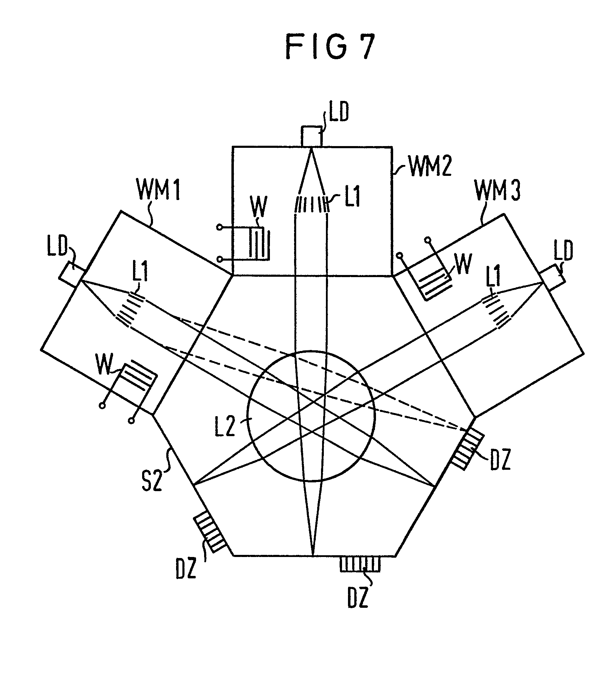

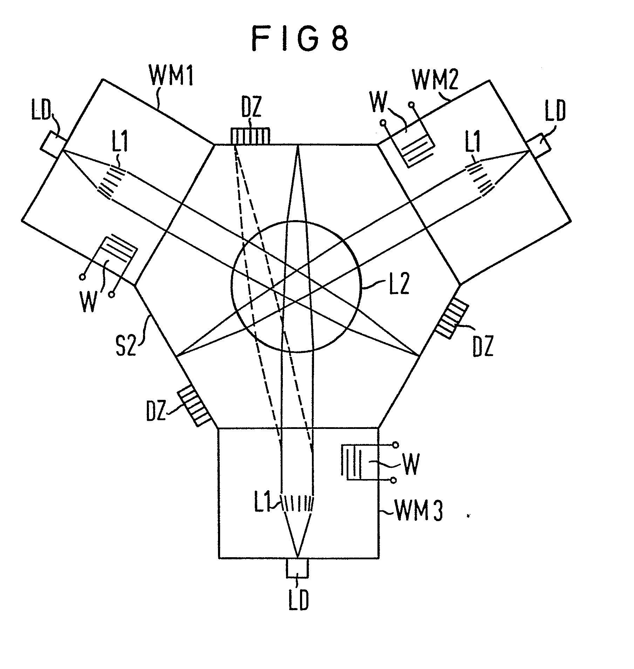

Figur 7 und Figur 8 in Draufsicht jeweils eine Ausführungsform eines Frequenzanalysators, bei dem mehreren Wellenleitermodulatoren eine gemeinsamen
Linse für die Fourier-Transformation zugeordnet ist.

Der in den Figuren 1a und 1b dargestellte Frequenzanalysator besteht aus zwei stoßgekoppelten Substraten S1 und S2, die aus verschiedenen Materialien bestehen. Das Substrat S1 trägt im wesentlichen den modulatoroptischen Teil und besteht aus $LiNbO_3$, in das ein Ti-eindiffundierter planarer oder Schichtwellenleiter WL1 eindiffundiert ist. Auf dem Substrat S1 sind die Elektrodenstruktur eines elektroakustischen Wandlers W und eine Bragg-Linse (siehe S.K.Yao, D.E.Thompon: Chirp-grating lens for guided-wave optics, Appl. Phys. Lett. 33 (1978) 635-637) fotolithografisch aufgebracht, die als Linse L1 zur Kollimation des Lichts einer Laserdiode LD dient, deren Licht in den Wellenleiter WL1 über dessen Stirnfläche eingekoppelt ist. Eine Bragg-Linse ist als Linse L1 gut geeignet und sie ist ebenfalls in einem Planarprozeß herstellbar. Die hohe Winkelselektivität von Bragg-Linsen tritt bei der Kollimation nicht in Erscheinung, wäre aber bei einer Linse L2 für die Fourier-Transformation von Nachteil. Aus diesem Grunde ist die Linse L2 zur Fourier-Transformation als eine geodätische Linse ausgebildet.

Die Linse L2 ist auf dem Substrat S2 ausgebildet, das aus einem Material besteht, in das die Linsenstruktur einprägbar ist.

Die Linse L2 wird kostengünstig folgendermaßen hergestellt: Ein Stempel mit der Negativform der geodätischen Struktur, die beispielsweise in einer kreisrunden, muldenförmigen Vertiefung besteht, wird mit einer numerisch gesteuerten Drehbank gefertigt. Mit dem Stempel können dann in einem Heißpreßverfahren beliebig viel Substrate mit Linsensturkturen versehen werden. Geeignete Substratmaterialien sind Glas oder Kunststoff und es sind bereits geeignete Gläser in der Entwicklung. Der erforderliche Wellenleiter WL2 auf dem Substrat S2 kann auf vielfältige Art erzeugt werden. Er kann beispielsweise nach dem Erzeugen der Struktur durch Aufbringen einer oder mehrerer geeigneter Schichten auf die mit der Struktur versehene Fläche erzeugt werden oder durch Einbringen von Dotierstoffen unter diese Fläche, beispielsweise mittels Ionenimplantation oder Diffusion. Er kann auch bereits vor der Erzeugung der Struktur der Linse erzeugt worden sein.

Der Wellenleiter WL2 wird meist geringere Dämpfungswerte als Wellenleiter in $LiNbO_3$ aufweisen. Die Kopplung der beiden Wellenleiter WL1 und WL2 ist unkritisch, weil der Wellenleiter WL2 tiefer ausgeführt werden kann, als der Wellenleiter WL 1. Die Möglichkeit, daß der tiefere Wellenleiter WL2 mehr als eine Lichtwelle führt, ist unerheblich, weil die Brechkraft der geodätischen Linse L2 unabhängig vom Wellenmodus ist.

Um Fresnel-Reflexionen an der Koppelstelle der beiden Wellenleiter zu vermeiden, ist auf eine der beiden Stirnflächen der beiden Wellenleiter WL1 und WL2 bzw. Substrate S1 und S2 eine Antireflexschicht AR aufgebracht. An die von dem Wellenleiter WL1 bzw. Substrat S1 abgewandte Stirnseite des Wellenleiters WL2 bzw. Substrat S2 sind eine Detektorzeile DZ und ein Lichtabsorber A für das ungebeugte Licht gekoppelt. Bei der Detektorzeile DZ handelt es sich hier beispielsweise um einen Typ mit besonders geringen Detektorabständen, um die Frequenzauflösung der Bragg-Zelle L1 zu nutzen.

Aus den Figuren 2a und 2b ist der Einsatz einer konventionellen Detektorzeile DZ entnehmbar. Die verhältnismäßig großen Detektorabstände üblicher Detektorzeilen werden über eine fächerförmige Streifenwellenleiterstruktur WL3 den geringen Abständen der Frequenzkanäle in der Brennebene der Linse L2 zur Fourier-Transformation angepaßt (siehe J.T. Boyd, D.A. Ramey: Optical channel waveguide arrays coupled to integrated charge-coupled devices and their applications., SPIE, Vol. 76, Guided Wave Optical Systems and Devices II (1979) 141-147). In diesem Fall kann das Licht aus dem Streifenwellenleiter einfach über Leckwellenkopplung in die aufgeklebte Detektorzeile DZ gekoppelt werden, wodurch auch störende Reflexe vermieden werden. Auch die Justierung ist in diesem Fall einfacher als bei einer Stirnflächenkopplung. Bei $LiNbO_3$-Substraten ist dagegen eine Leckwellenkopplung nicht möglich, da der Brechungsindex eines solchen Substrats größer ist als alle bekannten Kleber. Aus der Verwendung verschiedener Substratmaterialien ergibt sich somit der Vorteil, daß auch die vorteilhafte Leckwellenkopplung möglich ist.

In den Figuren 3a und 3b ist eine vorteilhafte Ausführungsform dargestellt, die hinsichtlich dreier Aspekte vorteilhaft ist, die sich ebenfalls aus der Verwendung verschiedener Substratmaterialien ergeben. Da die geodätische Linsenstruktur, wie zuvor beschrieben, sehr einfach zu fertigen ist, kann auch die Linse L1 zur Kollimation des von der Laserdiode oder dem Laser LD kommenden Lichts praktisch ohne Mehraufwand ebenso wie die Linse L2 für die Fourier-Transformation als geodätische Linse hergestellt werden. Die notwendige Stoß- oder Koppelstelle zwischen dem Wellenleiter LW4 auf dem Glassubstrat S3 für die Linse L1 und dem Wellenleiter LW1 auf dem $LiNbO_3$-Substrat mit

dem Wandler W führt allerdings nur dann zu tolerierbaren Verlusten, wenn der Wellenleiter LW4 auf dem Glassubstrat ebenso flach ist, wie der Wellenleiter LW1.

Der dynamische Bereich und die Frequenzauflösung des planaren Frequenzanalysators sind im wesentlichen durch Streulicht begrenzt, das im Wellenleiter entsteht. Glaswellenleiter sind Wellenleitern in $LiNbO_3$ in dieser Hinsicht überlegen. In $LiNbO_3$ müssen die Brennweiten der Linsen relativ kurz gewählt werden, weil nur Kristalle mit etwa 75 mm Durchmesser verfügbar sind, und auch weil das Streulicht bzw. auch die optische Dämpfung in langen Wellenleitern eine zu niedrige Dynamik des Frequenzanalysators zur Folge haben. In Gläsern können wahrscheinlich Wellenleiter mit besseren optischen Eigenschaften hergestellt werden, als in $LiNbO_3$ (beispielsweise durch Aufdampfen einer Schicht oder durch Ionenaustausch, Ionenimplantation), und die verfügbaren Substrate sind größer und billiger. Dadurch kann für die Linse L2 für die Fourier-Transformation eine größere Brennweite gewählt werden, was zur Folge hat, daß bei gleicher Frequenzauflösung eine Detektorzeile DZ mit konventionellem Detektorabstand verwendet werden kann, oder daß mit den bei $LiNbO_3$-Frequenzanalysatoren erforderlichen kleineren Detektorabständen der Detektorzeile DZ eine höhere Frequenzauflösung erzielt werden kann. Die bei Glas erhältlichen Substratgrößen erlauben auch die Herstellung eines Vielfachen von Linsen mit nur einer Stirnflächenbearbeitung. Aus der größeren Baulänge ergibt sich auch die Möglichkeit, den Abstand der Linse L2 zur Fourier-Transformation von der Bragg-Zelle auf dem Substrat S1 so groß zu wählen, daß das ungebeugte Licht an der Linse vorbeiläuft und vollständig vom Lichtabsorber A erfaßt wird. Die Folge wäre eine weitere Verminderung des Streulichts an der Detektorzeile DZ, weil die Linse als Streuzentrum nicht mehr auf das intensive ungebeugte Licht wirkt.

Ti-eindiffundierte Wellenleiter in LiNbO$_3$ können durch zu hohe Leistungsdichten des geführten Lichts zerstört werden. Dieser Effekt tritt bevorzugt an den Stellen des Wellenleiters auf, wo das Licht fokussiert ist, und zwar wegen der extrem hohen Leistungsdichten an solchen Stellen. Die Folge ist schließlich eine Verminderung der Frequenzauflösung des Frequenzanalysators . Dieses Problem wird vermieden, wenn am Ort der Laserdiode LD und der Diodenzeile DZ · Glaswellenleiter verwendet werden, in denen kein "optical damage" auftritt. Die Ausführungsform gemäß den Figuren 3a und 3b genügt dieser Bedingung vollauf.

Die Ausführungsform des in der Figur 4 dargestellten Frequenzanalysators besteht, wie die Ausführungsform gemäß Figur 1, im wesentlichen aus zwei Substraten S1 und S2. Während das linke Substrat S1 mit der Laserdiode LD, der Bragg-Linse L1 und dem Schallwandler W dem Substrat S1 in Figur 1 entspricht, ist das Glassubstrat S2 mit der geodätischen Linse L2 in Figur 1 durch eine stabförmige Gradientenlinse L2 ersetzt. Eine Antireflexschicht AR vermeidet auch hier Lichtverluste, die durch Reflexion am Brechzahlsprung von LiNbO$_3$ auf Glas entstehen. An die von dem Substrat S1 abgewandte Stirnfläche der Gradientenlinse L2 ist eine konventionelle Detektorzeile DZ montiert.

In allen bisherigen Beispielen wurde das Licht einer Laserdiode LD über eine Stirnfläche in den Wellenleiter LW1 eingekoppelt. Das Licht kann aber auch über Prismenkopplung in den Wellenleiter gelangen. In den Figuren 5a und b und Figur 6 sind dazu zwei Ausführungsbeispiele dargestellt. Die Figuren 5a und b zeigen in Seitenansicht und Draufsicht eine Anordnung zur Einkopplung von kollimiertem Licht einer externen Quelle, beispielsweise eine Gaslasers, über ein über oder auf dem Wellenleiter angeordnetes Einkoppelprisma EP. Im Ausführungsbeispiel nach Figur 6 geht das Licht wieder von einer Laserdiode LD aus, und wird von einer Gradientenlinse L1 kollimiert, bevor es in das Einkoppelprisma EP eintritt. Die Laserdiode LD, die Gradientenlinse L1 und das Einkoppelprisma EP sind aneinandergekittet und bilden eine kompakte Einheit. In beiden Beispielen ist das Einkoppelprisma mit mechanischem Druck P an den Wellenleiter gepreßt. Zur Verbesserung des Wirkungsgrades der Prismenkopplung bilden die Prismengrundfläche und die Substratoberfläche einen keilförmigen Luftspalt. Dieser wird erreicht mit einem dünnen Steg Stg, der auf das Substrat S1 aufgedampft ist. In beiden Fällen ersetzt die Anordnung mit dem Einkoppelprisma EP die Wellenleiterlinse (Bragg-Linse oder geodätische Wellenleiterlinse) für die Kollimation von Licht.

Aus den Figuren 7 und 8 gehen Ausführungsformen hervor, bei denen das von mehreren unabhängigen Wellenleitermodulatoren in Form von Bragg-Zellen modulierte Licht dieselbe Linse L2 zur Fourier-Transformation durchsetzt.

Die zentrale Komponente des Mehrfachfrequenzanalysators gemäß den Figuren 7 und 8 ist eine Wellenleiterlinse L2 in der Mitte eines Substrats S2 in der Form eines regelmäßigen Vielecks mit gerader Kantenzahl. Für die Wellenleiterlinse L2 kommen alle rotationssymmetrischen Typen in Frage, wie beispielsweise geodätische Linsen oder Luneberg-Linsen. Die Wellenleiterlinse L2 hat die Aufgabe, das von mehreren Wellenleitermodulatoren WM1, WM2, WM 3 kommende parallele Licht zu fokussieren und dient damit zur Fourier-Transformation der HF-Signale. Die Wellenleitermodulatoren WM1 bis WM3
können beispielsweise Bragg-Zellen sein. Die Substrate mit den Bragg-Zellen sind auf Stoß an die
Kanten bzw. Seiten des vieleckigen Substrats mit der
Linse L2 gekoppelt. Auf den Substraten der Bragg-
zellen können auch die Linsen L1 zur Kollimation
des von den zugeordneten Laserdioden LD ausgehenden
Lichts angeordnet sein. Es sind aber auch alle vorstehend bereits vorgeschlagenen Varianten möglich.
Das gleiche gilt für die Kopplung der Detektorzeilen
DZ an die Kanten bzw. Seiten des Substrats S2.
Jeder Bragg-Zelle ist auf der gegenüberliegenden
Seite des Substrats S2 je eine Detektorzeile DZ
zugeordnet.

In der Ausführungsform gemäß Figur 7 sind benachbarte Wellenleitermodulatoren an aneinanderstoßende
Seiten des Vielecks gekoppelt. Die in der Figur 8
dargestellte Ausführungsform unterscheidet sich
von der Ausführungsform gemäß Figur 7 dadurch, daß
benachbarte Wellenleitermodulatoren an Seiten des
vieleckigen Substrats S2 gekoppelt sind, die durch
eine weitere Seite des Vielecks voneinander getrennt
sind. Dadurch wird eine Vergrößerung des dynamischen
Bereichs erreicht. Die Detektorzeilen DZ werden nur
von den rückgestreuten Lichtanteil benachbarter
Frequenzanalysatoren getroffen, während es in der
Ausführungsform gemäß Figur 7 der vorwärts gestreute
Anteil ist. Der rückgestreute Lichtanteil ist im
allgemeinen geringer als der vorwärts gestreute.

Die Herstellung der Linse L2 für die Fourier-Transformation ist zur Zeit der aufwendigste Arbeitsschritt
bei der Herstellung eines integriert-optischen Frequenzanalysators. Durch die Mehrfachnutzung der Linse
L2 für die Fourier-Transformation vereinfacht der
Aufbau gemäß den Figuren 7 und 8 demgemäß die Herstellung von Anlagen parallel betriebener Bragg-Zellen-Empfänger, verglichen mit Anlagen, mit denen jeder Bragg-Zellen-Empfänger mit einer eigenen Linse zur Fourier-Transformation ausgestattet ist.

Solche Mehrfach-Bragg-Zellen-Empfänger können eingesetzt werden, beispielsweise zur Fourier-Transformation mehrdimensionaler Signale oder zur gleichzeitigen Frequenzanalyse mehrerer HF-Bänder.

12 Patentansprüche
8 Figuren

<u>Patentansprüche</u>

1. Frequenzanalysator in planarer Wellenleitertechnologie, mit einem mindestens einen planaren Wellenleitermodulator für eine Lichtmodulation aufweisenden modulatoroptischen Teil und einem, mindestens eine, dem Wellenleitermodulator nachgeordnete geodätische Linse für eine Fourier-Transformation aufweisenden linsenoptischen Teil auf einem Substrat, d a d u r c h g e k e n n z e i c h n e t , daß für den modulatoroptischen Teil (S1, WM1 bis WM3) und dem linsenoptischen Teil (S2) verschiedene Substratmaterialien vorgesehen sind.

2. Frequenzanalysator nach Anspruch 1, d a d u r c h g e k e n n z e i c h n e t , daß das Substratmaterial für den linsenoptischen Teil (S2) aus einem Material besteht, in dem eine geodätische Linse durch Pressen mit einem Stempel erzeugbar ist.

3. Frequenzanalysator nach Anspruch 2, d a d u r c h g e k e n n z e i c h n e t , daß das Substratmaterial für den linsenoptischen Teil (S2) aus einem Material besteht, in dem die Linse in einem Heißpreßverfahren erzeugbar ist.

4. Frequenzanalysator nach einem der vorhergehenden Ansprüche, d a d u r c h g e k e n n z e i c h n e t , daß das Substratmaterial des linsenoptischen Teils (S2) aus einem Material besteht, in dem eine Gradientenlinse ausgebildet ist.

5. Frequenzanalysator nach Anspruch 4, d a d u r c h g e k e n n z e i c h n e t , daß das Substratmaterial der Gradientenlinse in Form eines Stabes ausgebildet ist.

6. Frequenzanalysator nach einem der vorhergehenden Ansprüche, d a d u r c h  g e k e n n z e i c h n e t , daß das Substratmaterial für den linsenoptischen Teil (S2) aus einem Glas oder Kunststoff besteht.

7. Frequenzanalysator nach einem der vorhergehenden Ansprüche, d a d u r c h  g e k e n n z e i c h n e t , daß das Substrat für den modulatoroptischen Teil (S1, WM1 bis WM3) aus LiNbO$_3$ besteht.

8. Frequenzanalysator nach einem der vorhergehenden Ansprüche, d a d u r c h  g e k e n n z e i c h n e t , daß die einzelnen Bauteile (S1, S2, S3, WM1 bis WM3) aus verschiedenen Substratmaterialien durch Stoßkopplung miteinander verbunden sind.

9. Frequenzanalysator nach Anspruch 8, d a d u r c h  g e k e n n z e i c h n e t , daß zwischen stoß-gekoppelten Teilen eine Antireflexschicht (AR) vorgesehen ist.

10. Frequenzanalysator nach einem der vorhergehenden Ansprüche, insbesondere nach Anspruch 8 oder 9, d a d u r c h  g e k e n n z e i c h n e t , daß der linsenoptische Teil (S2, S3) eine einem Wellenleitermodulator (W) des modulatoroptischen Teils (S1) vorgeordnete, in einem vom Substratmaterial des modulatoroptischen Teils verschiedenen Substratmaterial ausgebildete geodätische Linse (L1) für eine Kollimation des in den Wellenleitermodulator einzukoppelnden Lichts aufweist (Figuren 3a und b).

11. Frequenzanalysator in planarer Wellenleitertechnologie mit einem, mindestens einen planaren Wellenleitermodulator für eine Lichtmodulation aufweisenden modulatoroptischen Teil und einem, mindestens eine, dem Wellenleitermodulator nachgeordnete geodätische Linse für eine Fourier-Transformation ausweisenden linsenoptischen Teil auf einem Substrat, insbesondere Frequenzanalysator nach einem der vorhergehenden Ansprüche, d a d u r c h g e k e n n z e i c h - n e t , daß die als rotationssymmetrische Wellenleiterlinse ausgebildete geodätische Linse für die Fourier-Transformation mehrere über den Umfang der Linse verteilten Wellenleitermodulatoren des modulatoroptischen Teils als gemeinsame Linse für die Fourier-Transformation nachgeordnet ist (Figuren 7 und 8).

12. Frequenzanalysator nach Anspruch 11 und Anspruch 8 oder 9, d a d u r c h g e k e n n z e i c h - n e t , daß die gemeinsame Linse auf oder in einem polygonförmigen Substrat (S2) ausgebildet ist, an dessen Seitenflächen die mehreren Wellenleitermodulatoren des modulatoroptischen Teils stoßgekoppelt sind.

1/5

FIG 1a

FIG 1b

FIG 2a

FIG 2b

## FIG 3a

## FIG 3b

## FIG 4

FIG 5a

FIG 5b

FIG 6

FIG 7

FIG 8